Europäisches Patentamt

(19) European Patent Office

Office européen des brevets

(11) Publication number : **0 322 060 B1**

(12) **EUROPEAN PATENT SPECIFICATION**

(45) Date of publication of patent specification :
**11.10.95 Bulletin 95/41**

(51) Int. Cl.$^6$ : **H03H 21/00, H03H 17/02**

(21) Application number : **88202945.7**

(22) Date of filing : **19.12.88**

(54) Adjusting filter coefficients.

(30) Priority : **23.12.87 GB 8729988**

(43) Date of publication of application :
**28.06.89 Bulletin 89/26**

(45) Publication of the grant of the patent :
**11.10.95 Bulletin 95/41**

(84) Designated Contracting States :
**DE FR GB IT**

(56) References cited :
**DE-A- 2 724 561
INTERNATIONAL JOURNAL OF ELEC-
TRONICS, vol. 53, no. 1, 1982, pages 95-99,
Taylor & Francis Ltd, London, GB; M.A.
SODERSTRAND et al.:"Experimental perform-
ance data for slowed-down adaptive
algorithms"**

(73) Proprietor : **PHILIPS ELECTRONICS UK
LIMITED
420-430 London Road
Croydon CR9 3QR (GB)**
(84) **GB**
Proprietor : **Philips Electronics N.V.
Groenewoudseweg 1
NL-5621 BA Eindhoven (NL)**
(84) **DE FR IT**

(72) Inventor : **Gurcan, Mustafa c/o PHILIPS
ELECTRONICS
Patent and Trade Marks Department
Centre Point
New Oxford Street London WC1A 1QJ (GB)**
Inventor : **De Bekker, Frank c/o PHILIPS
INTERNATIONAL B.V.
Corporate Patents and Trademarks
Prof. Holstlaan 6
NL-5656 AA Eindhoven (NL)**
Inventor : **Newton, David John
c/o PHILIPS RESEARCH LABORATORIES
Redhill Surrey RH1 5HA (GB)**

(74) Representative : **Moody, Colin James et al
Philips Electronics UK Limited
Patents and Trade Marks Department
Cross Oak Lane
Redhill, Surrey RH1 5HA (GB)**

## Description

This invention relates to a method of adjusting the weighting coefficients corresponding to N successive stages of a transversal filter according to the least means squares algorithm, in which method signal samples are supplied to the filter in succession, differences between output signals of the filter and a reference are determined, which output signals each result from a respective group of N of said samples being weighted by said weighting coefficients, and a respective correction derived from the product of a said difference and the current content of a stage of the filter is applied to each said weighting coefficient. The invention also relates to a modification of such a method in which inter alia the transversal filter is replaced by a decision feedback filter. Moreover the invention relates to arrangements for implementing such methods.

It is often required that the weighting coefficients of a transversal filter be adjusted in order to render the filter characteristic closer to that currently required. For example, such a filter may be employed as a so-called "equaliser" for compensating for distortion to a transmitted signal caused by the imperfect nature of a transmission channel. If the channel characteristics vary with time then, in order that satisfactory equalisation continues to be achieved, it is necessary that the filter characteristic be updated either effectively continuously or periodically to take into account the changed channel characteristics. To this end methods of the general kind defined in the first paragraph are well-known, the "least mean squares algorithm" being one of several algorithms which could be employed for the adjustment process.

DE-A-2 724 561 discloses a transversal filter comprising a shift register comprising a plurality of stages, each of which stages is coupled to a respective multiplier in which an output of the shift register stage is multiplied by a weighting coefficient. The outputs of the multipliers are summed to provide a filter output signal. The weighting coefficients are adjusted by subtracting the filter output signal relating to a periodically transmitted training sequence from a locally generated reference signal and the difference is used to calculate the weighting coefficients by multiplying the input signal to the shift register by the difference signal and summing the result. The algorithm used is not least mean squares but one which makes use of the mean value of another suitable function of the error, for example

$$E^* = \lim_{K \to \infty} \frac{1}{K} \sum_{k=-K}^{K} |e_k|$$

where $e_k$ is the error

In the known methods each coefficient is adjusted once for every sample applied to the filter according to the formulae:

$$C_1(k + 1) = C_1(k) + \mu e(k) V_1(k)$$
$$C_2(k + 1) = C_2(k) + \mu e(k) V_2(k)$$
$$-$$
$$-$$
$$-$$
$$C_N(k + 1) = C_N(k) + \mu e(k) V_N(k).$$

where $C_1(k)$, $C_2(k)$ ... $C_N(k)$ are the weighting coefficients corresponding to the N successive stages of the filter for a given sample period k of the input signal, $\mu$ is a constant which is usually less than 0.1, $e(k)$ is the difference between the output of the filter and the reference for the given sample period k, and $V_1(k)$, $V_2(k)$, ... $V_N(k)$ are the respective contents of the N successive stages of the filter for the given sample period k. This adjustment of every coefficient once for every sample period gives theoretically optimum results in respect of speed of acquisition of the required characteristic. However, the large amount of computation required in order to achieve this implies a relatively large power consumption, which can be a disadvantage in many applications. It is an object of the invention to mitigate this disadvantage.

According to one aspect of the present invention there is provided a method of adjusting the weighting coefficients corresponding to N successive stages of a transversal filter according to the least mean squares algorithm, in which method signal samples are supplied to the filter in succession, differences between output signals of the filter and a reference are determined, which output signals each result from a respective group of N of said samples being weighted by said weighting coefficients, and a respective correction derived from the product of a said difference and the current content of a stage of the filter is applied to each said weighting coefficient, characterised in that the filter includes at least one further stage which succeeds the N successive stages and the weighting coefficient corresponding to which is set to zero for the production of each said output signal, in that each of the N coefficients is adjusted only once for each n samples applied to the filter, where n is greater than unity, and in that each correction is derived from the output of the filter after the entering of values representative of a plurality of said differences into the filter as respective weighting coefficients and the setting of any remaining weighting coefficients to zero.

It has now been recognised that the quantity $C_x(k)$ on the right-hand side of each of the above formulae is itself given by a similar formula in which the corresponding quantity on the right-hand side is itself given by a similar formula, etc. etc. Thus, for example, the formula $C_1(k+1) = C_1(k) + \mu e(k) V_1(k)$ can be expanded as follows

$$C_1(k + 1) = C_1(k) + \mu e(k) V_1(k)$$
$$= C_1(k - 1) + \mu e(k - 1) V_1(k - 1) + \mu e(k) V_1(k)$$
$$= C_1(k - 2) + \mu e(k - 2) V_1(k - 2) + \mu e(k - 1) V_1(k - 1) + \mu e(k) V_1(k)$$

etc. Once this has been done it becomes apparent that $C_1$ may be adjusted, for example, once for every two sample periods of the input signal using the expression

$$C_1(k+1) = C_1(k-1) + \mu[e(k-1) V_1(k-1) + e(k) V_1(k)],$$

provided that the quantities inside the square brackets are known at the relevant time. In fact the quantity $V_1(k-1)$ will still be present in the filter, because $V_1(k-1) = V_2(k)$ so that the only quantity which needs to be saved is $e(k-1)$. Similarly $C_1$ could be adjusted only once for every three samples of the input signal using the relevant expression quoted above provided that the quantities $e(k-2)$ and $e(k-1)$ are saved (and assuming that the filter comprises at least three stages so that the quantity $V_1(k-2) = V_3(k)$ is still present). Moreover, it will be noted that the quantity inside the square brackets above (and the corresponding quantity if $C_1$ were adjusted more infrequently than once for every two sample periods) is in "sum of products" form. This is exactly the form of calculation performed by a transversal filter. Thus, for example, the filter itself can be made to evaluate the quantity inside the square brackets above by the simple expedient of substituting the quantities $e(k)$ and $e(k-1)$ for the weighting coefficients $C_1$ and $C_2$ respectively, and setting any other weighting coefficients to zero.

If, for example, the weighting coefficient $C_N$ is treated in a similar way, we have

$$C_N(k + 1) = C_N(k) + \mu e(k) V_N(k)$$
$$= C_N(k - 1) + \mu e(k - 1) V_N(k - 1) + \mu e(k) V_N(k)$$
$$= C_N(k - 2) + \mu e(k - 2) V_N(k - 2) + \mu e(k - 1) V_N(k - 1) + \mu e(k) V_N(k)$$

etc. In this case it will be noted that, if the filter were to have exactly N stages, although the quantity $V_N(k)$ would be present in the filter for the sample period k, the quantities $V_N(k-1)$, $V_N(k-2)$ etc. will have dropped out of the end. Therefore, if one of the above formulae is to be applied then, if $C_N$ is to be adjusted once for every n sample periods of the input signal and a respective said output signal is produced for each signal sample applied to the filter, the filter will have to be provided with at least n-1 further stages succeeding the N stages so that the quantities $V_N(k-1) \dots V_N(k-(n-1))$ do not drop out until they are no longer needed. Provided that this is done the quantity $[e(k)V_N(k) + e(k-1) V_N(k-1) + \dots, + e(k-(n-1)) V_N(k-(n-1))]$ may be evaluated by means of the filter in a similar way to that set forth above, i.e. by substituting the quantities $e(k)$, $e(k-1) \dots e(k-(n-1))$ for the coefficients $C_N$, $C_{N+1}, \dots C_{N+n-1}$ respectively and setting the remaining coefficients to zero. It should be noted however that in some cases satisfactory results may still be obtained if less than n-1 further stages are provided, so that the corrections for the coefficients which correspond to at least some of the N successive stages are derived using less than the total amount of information which would otherwise be available, the "oldest" of this information being in fact that which is not used.

In order to minimise the amount of calculation carried out serially for each sample period it may be arranged, if a respective said output signal is produced for each signal sample applied to the filter, that n=N and one correction for a coefficient is derived for each sample applied to the filter. However, it may as an alternative be preferred in some circumstances and if N is even, to choose for example n=N/2 and derive two corrections for respective coefficients for each sample applied to the filter. This can allow the total number of stages in the filter to be reduced.

The aforesaid one aspect of the present invention can be employed to adjust the weighting coefficients of a so-called "decision feedback" filter if it is arranged that the input signals to the filter are in multiplexed form. More specifically, it may be arranged that a respective said output signal is produced for each pair of signal samples applied to the filter and that alternate ones of said signal samples are derived from a said output signal via a decision element, and from an external signal source respectively.

According to second aspect of the present invention there is provided a method of adjusting the weighting coefficients corresponding to N stages of a decision feedback filter arrangement according to the least mean squares algorithm, said filter arrangement comprising first and second transversal filters having a common output which is coupled to the input of the second filter via a decision element, X successive stages of the first filter and Y successive stages of the second filter together constituting said N stages, in which method signal samples are supplied to the first filter in succession, differences between output signals appearing at said common output and corresponding signals appearing at the decision element output are determined, and a respective correction derived from the product of a said difference and the current content of a stage of a said filter is applied to each said weighting coefficient, each said output signal appearing at said common output resulting from a respective group of X of said samples and Y of the signals derived from the decision element output which are applied to the second filter being weighted by said weighting coefficients, characterised in that the first filter includes at least one further stage which succeeds said X successive stage and the second filter includes at least one further stage which succeeds said Y successive stage, the weighting coefficients corresponding to said further stages being set to zero for the production of each said output signal appearing at said common output, in that each of the N coefficients is adjusted only once for each n samples applied to the first filter, where n is greater than unity, in that each correction for a weighting coefficient corresponding to one of the X stages of the first filter is derived from the output of the first filter after the entering of values representative of a plurality of said differences into the first filter as respective weighting coefficients and the setting of any remaining weighting coefficients therein to zero, and in that each correction for a weighting coefficient corresponding to one of the Y stages of the second filter is derived from the output of the second filter after the entering of values representative of a plurality of said differences into the second filter as respective weighting coefficients and the setting of any remaining weighting coefficients therein to zero.

According to a third aspect of the present invention there is provided a transversal filter arrangement comprising a transversal filter having at least N successive stages, means for supplying signal samples to the filter in succession, means for determining differences between output signals of the filter and a reference, which output signals each result from a respective group of N of said samples being weighted by the weighting coefficients corresponding to the N successive stages, and weighting coefficient adjusting means for adjusting each said weighting coefficient according to the least mean squares algorithm by applying to the coefficient a respective correction derived from the product of a said difference and the current content of a stage of the filter, characterised in that the filter includes at least one further stage which succeeds the N successive stages, in that means are provided for setting the weighting coefficient corresponding to said further stage to zero for the production of each said weighting coefficient, and in that said weighting coefficient adjusting means is arranged to adjust each of the N coefficients only once for each $n$ samples applied to the filter, where $n$ is greater than unity, and to derive each correction from the output of the filter after entering values representative of a plurality of said differences into the filter as respective weighting coefficients and setting any remaining weighting coefficients to zero.

According to a fourth aspect of the present invention there is provided a decision feedback filter arrangement comprising first and second transversal filters having a common output which is coupled to the input of the second filter via a decision element, means for supplying signal samples to the first filter in succession, means for determining differences between signals appearing at said common output and corresponding signals appearing at the decision element output, and weighting coefficient adjusting means for adjusting the weighting coefficients corresponding to X successive stages of the first filter and Y successive stages of the second filter in accordance with the least mean squares algorithm by applying to each said weighting coefficient a respective correction derived from the product of a said difference and the current content of stage of a said filter, each said output signal appearing at said common output resulting from a respective group of X of said samples and Y of the signals derived from the decision element output which are applied to the second filter being weighted by said weighting coefficients, characterised in that the first filter includes at least one further stage which succeeds said X successive stages and the second filter includes at least one further stage which succeeds said Y successive stages, in that means are provided for setting the weighting coefficients corresponding to said further stages to zero for the production of each said output signal appearing at said common output, and in that said weighting coefficient adjusting means is arranged to adjust each of the X+Y coefficients only once for each $n$ samples applied to the first filter, where $n$ is greater than unity, to derive each correction for a weighting coefficient corresponding to one of the X stages of the first filter from the output of the first filter after entering values representative of a plurality of said differences into the first filter as respective weighting coefficients and setting any remaining weighting coefficients to zero, and to derive each correction for a weighting coefficient corresponding to one of the Y stages of the second filter from the output of the second filter after entering values representative of a plurality of said differences into the second filter as respective weighting coefficients and setting any remaining weighting coefficients therein to zero.

Embodiments of the invention will now be described, by way of example, with reference to the accompanying diagrammatic drawings, in which

Figure 1 is a block diagram of a first embodiment,

Figure 2 illustrates the time relationship between some control signals occurring in the embodiment of Figure 1,

Figure 3 illustrates some information signals occurring in the embodiment of Figure 1,

Figure 4 illustrates some information signals occurring in a modified version of the embodiment of Figure 1,

Figure 5 illustrates some information signals occurring in another modified version of the embodiment of Figure 1, and

Figure 6 illustrates some information signals occurring in yet another modified version of the embodiment of Figure 1.

In the drawing a transversal filter arrangement comprises a conventional transversal filter 1 in the form of a delay line or shift register 2 having (N+n-1) stages, a multiplier array 3 comprising a respective multiplier corresponding to each stage of the register 2, and an adder 4 which adds together the outputs of all the multipliers of the array 3 and produces the result on an output 5. Each multiplier of the array 3 has a first input coupled to an output of the corresponding stage of the register 2 and a second input fed from a respective group of bit-lines of a multiple input 6 and multiplies the content of the corresponding stage of the register 2 by a (digital) quantity applied in operation to the respective group of bit lines of the input 6. The serial input 7 of the shift register 2 is also multibit, as is the storage capacity of each stage of the register 2. The input 6 is fed from the parallel outputs of a first auxiliary register 8 and a second auxiliary register 9 as alternatives via a two-position multiplexer 10. Each of the registers 9 and 10 contains a multibit storage stage corresponding to each multiplier of the array 3 and, when the multiplexer connects the parallel output of the relevant register 9 or 10 to the input 6, the content of each stage is applied to the bit lines of the input 6 which feed the corresponding multiplier. Thus the contents of the stages of the register 2 are weighted by the contents of the corresponding stages of the register 8 or 9 and the results are added together by the adder 4. The input 7 of the (clocked) shift register 2 is fed from an input terminal 11 via a correspondingly clocked sampling analog-to-digital converter 12. Input terminal 11 is connected to the output of an external signal source (not shown). Input 7 is therefore fed with a succession of samples $\underline{V}$ in digital form of an analogue input signal applied to terminal 11, these samples being clocked through the register 2 in succession and giving rise to corresponding filtered signal samples in digital form at the the output 5.

Output 5 is connected, via a two position demultiplexer 13, as alternatives to either the input of a multiplier 14 or to both the input of a decision element 15 and a first input of a subtractor 16. The output of decision element 15 feeds both an output 17 and also the second input of the subtractor 16. In known manner decision element 15 takes, on the basis of the potentially distorted signals fed to its input from the output 5, decisions on what these signals would ideally be in the absence of such distortion and produces the results of these decisions on its output, whence they are fed to the output 17. The decisions may be taken, for example, on the basis of a reference to all the possible values which the output signals of converter 12 could have in the absence of distortion or, as another example, on the basis of a reference to the undistorted form of a standard signal a potentially distorted version of which is periodically received on the input terminal 11. The difference $\underline{e}$ between the successive output signals of decision element 15 and the corresponding signals appearing at the output 5 of filter 1 are calculated by subtractor 16 and are clocked in succession into a shift register 18 via its serial input 19. Shift register 18 has $\underline{n}$ stages, and its parallel output 20 is connected to the parallel input 21 of the right-hand $\underline{n}$ stages of register 8, the remaining N-1 left-hand stages of register 8 being loaded with zeros on a permanent basis. The right-hand $\underline{n}$ stages of register 8 correspond to the $\underline{n}$ multipliers at the right-hand end of array 3.

Multiplier 14 multiplies the signals fed to it from the filter output 5 by a fixed constant value $\mu$, and applies the result to one input 22 of an adder 23. The other input 24 of adder 23 is fed with the contents of a selected one of the N left-hand stages of register 9 via an N-position multiplexer 25, these N left-hand stages corresponding to the N multipliers at the left-hand end of the array 3 (which contains N+n-1 multipliers in all). The remaining stages of register 9 are loaded with zeros on a permanant basis. The output of adder 23 is fed to the input of a selected one of the N left-hand stages of register 9 via an N-position demultiplexer 26, the stages selected by (de)multiplexers 25 and 26 at any given time being the same. Each of the said N left-hand stages also has a respective load signal input (not shown), and that stage which is at any given time selected by demultiplexer 26 also has its load signal input connected through demultiplexer 26 to a further bit input 27 of demultiplexer 26. Control or selection signal inputs 28 and 29 of the (de)multiplexers 25 and 26 respectively are fed from the output 30 of a counter 31 which has a capacity N. A "borrow" signal output 32 of counter 31 is connected to a parallel load input 34 of register 8. Register 8 is therefore loaded each time (decremented) counter 31 is changed to a state in which it controls (de)multiplexers 25 and 26 to select the Nth stage of register 9.

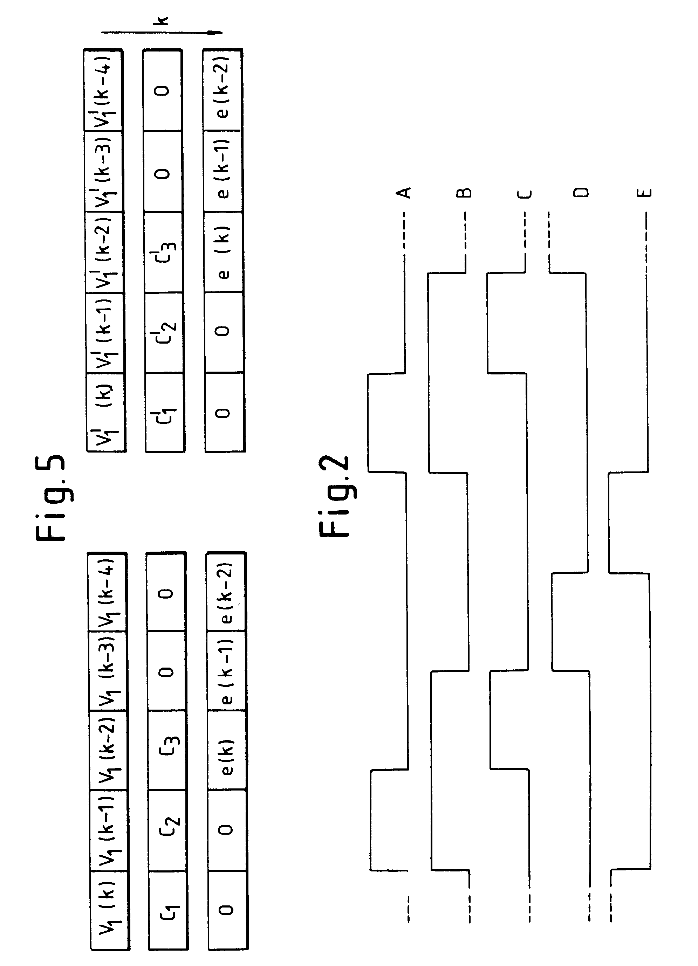

The components 2, 10, 12, 13, 18 and 31 are supplied with clock/control signals from outputs A, B, C, D and E of a clock/control signal generator 35 as shown. The time relationship between these signals is indicated in Figure 2 of the drawings. Signal A is applied to a sampling control signal input 36 of analog-to-digital converter 12 and to a clock signal input 37 of delay line or shift register 2, so that each time a rising edge occurs in the signal A, a sample is taken of a signal applied to input 11, is converted to digital form, and is clocked into the first stage of register 2. Signal B is applied to select signal inputs 38 and 39 of the (de)multiplexers 10 and 13. A high level in this signal causes multiplexer 10 to connect the parallel output of register 9 to input 6 and demultiplexer 13 to connect output 5 to decision device 15 and subtractor 16, these (de)multiplexers taking up their other selection state when signal B is low. Signal C is supplied to the clock signal input 40 of shift register 18 so that the output of subtractor 16 is loaded into the first stage of register 18 each time a rising edge occurs in signal C. Signal D is applied to the clock signal input 41 of (cyclic) counter 31, so that the content of counter 31 is decremented on each rising edge of signal D. Signal E is applied to the bit line input 27 of demultiplexer 26 so that the stage of register 9 currently selected by demultiplexer 26 is loaded with the output of adder 23 each time a rising edge occurs in the signal E.

In operation successive digital samples $\underline{V}$ of a signal applied to input 11 are clocked into shift register or delay line 2 under the control of signal A. During the first half of each sample period (signal B high) the corresponding output $\underline{I}$ of filter 1, using the contents of register 9 as the respective weighting coefficients $\underline{C}$, appears on output 17 after processing by the decision element 15. Moreover, the difference $\underline{(e)}=I-V$ between the input signal $\underline{V}$ to and the output signal $\underline{I}$ from decision element 15 is clocked into shift register 18 under the control of signal C. It will be noted that only the samples in the first N stages at most of register 2 contribute to the signal at output 17, because the contents of the stages of register 9 which correspond to the remaining stages of register 2 are permanently zero. The arrangement therefore operates effectively as an N-tap filter, even though register 2 comprises more than N stages.

During the second half of each sample period (signal B low) the contents $\underline{e}$ of register 8 are used for the filter weighting coefficients (only the samples in the last n stages at most of register 2 contributing to the resulting signal applied to multiplier 14 because the contents of the stages of register 8 which correspond to the remaining stages of register 2 are permanently zero). The resulting output of multiplier 14 is used to correct, under the control of signal E, the weighting coefficient contained in that stage of register 9 which is currently being selected by (de)multiplexers 25 and 26 under the control of counter 31. Because counter 31 is clocked by signal D once for every sample period the N coefficients stored in register 9 are corrected in turn, one per signal sample period, on a cyclic basis, the contents of register 8 being set to the current contents of register 18 prior to each correction of the Nth coefficient. It will be apparent from a consideration of the time relationship between the various signals that each of the N coefficients in register 9 is corrected once for evey N sample periods in a manner given by the formulae derived above. If n=N the maximum number of signal samples and errors is taken into account for the correction of each coefficient although, as mentioned previously, in some cases satisfactory results may be obtained if less than this number is taken into account, at least for the correction of some coefficients. In other words, in some cases satisfactory results may be obtained if $\underline{n}$ is less than N.

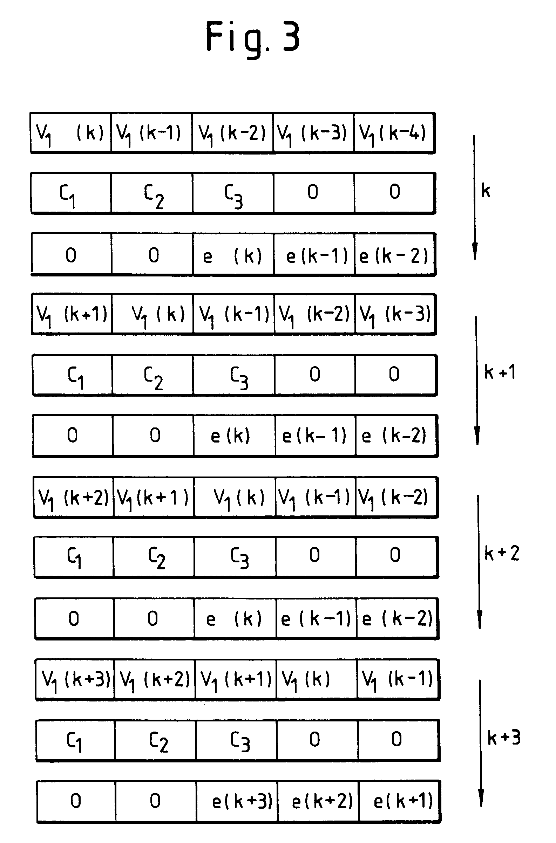

As an example Figure 3 illustrates for four successive sample periods k, k+1, k+2, k+3, the contents V of the stages of the shift register 2 and, beneath each one, the corresponding weighting coefficients employed during the first and during the second halves of the relevant sample period, for N=n=3. $V_1(k)$ is the content of the first stage of the register during the sample period k and $e(k)=I(k)-V(k)$ is the corresponding output of subtractor 16 during the first half of that sample period. It will be seen that during the second half of sample period $\underline{k}$ the output of multiplier 14 is $\mu[e(k) V_1(k-2) + e(k-1) \overline{V_1}(k-3) + e(k-2) V_1(k-4)]$,

i.e. the required correction for the weighting coefficient $C_3$ for the third stage of the register. Similarly, during the second half of sample periods k+1, k+2 and k+3 the outputs from multiplier 14 are the required corrections for the weighting coefficients for the second $(C_2)$, first $(C_1)$ and third $(C_3)$ stages of register 2, as required.

It should be noted that an integrated circuit having an architecture corresponding to the combination of the items 1, 8, 9 and 10 is commercially available from Inmos under the type number A100, and such an integrated circuit may be used to implement these components. If this is done the arrangement of the clock/control signal generator 35, (de)multiplexers 25 and 26, and counter 31 will have to be modified somewhat to take into account that with this integrated circuit the various stages of the registers 8 and 9 have to be accessed by applying appropriate address signals to the circuit.

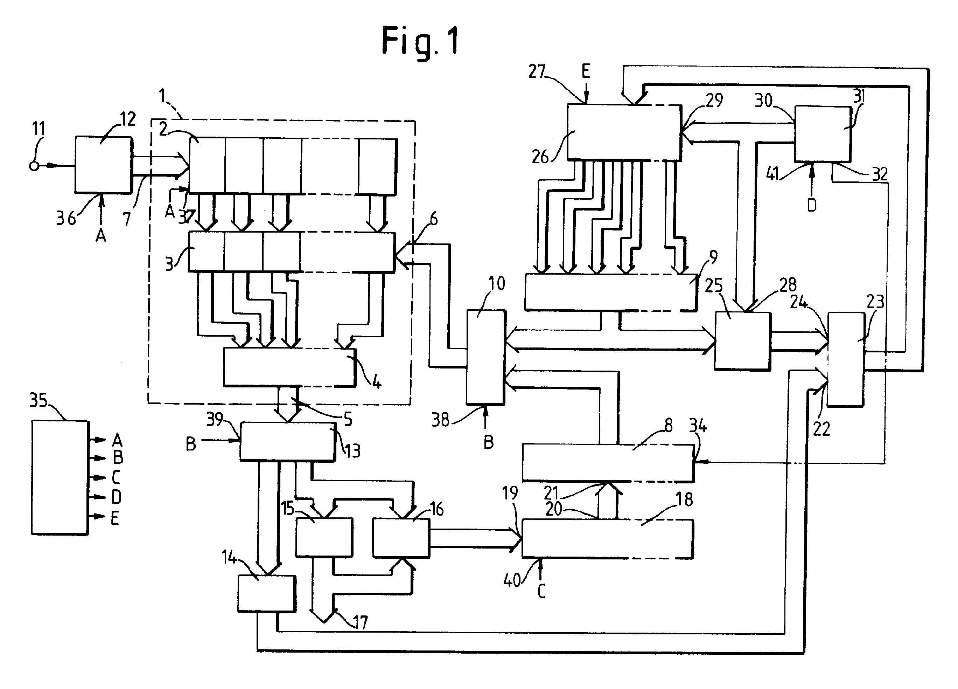

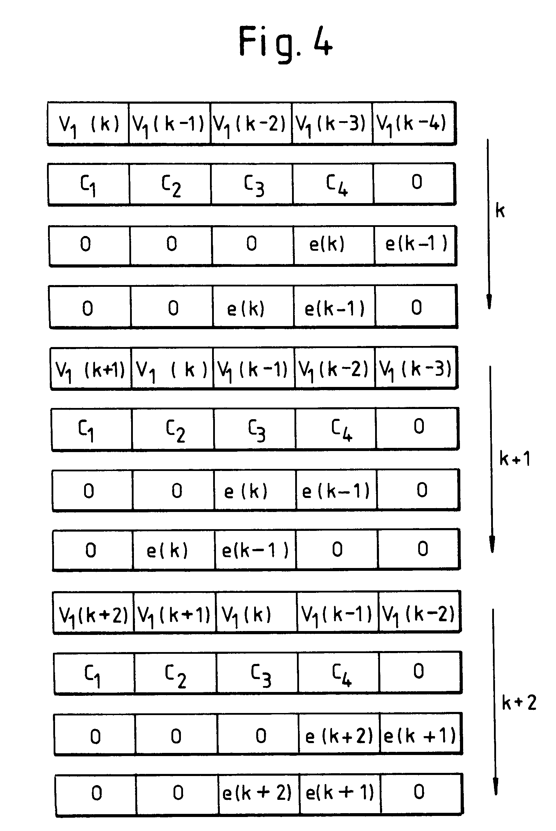

As described so far, one of the N coefficients in register 9 is adjusted for each sample period of the signal applied to input 11. In fact, if desired, more than one coefficient may be adjusted for each said period, enabling the excess of the number of stages of register 2 over N to be reduced while still taking into account the maximum amount of information for the adjustment of each coefficient, albeit at the expense of having to carry out more operations during each sample period. Figure 4 is a diagram, similar to Figure 3, showing how it may be arranged that two of the N coefficients are adjusted during the latter part of each sample period. Again in this example register 2 has five stages, but now N=4 and each coefficient is adjusted once for every n=2 sample periods. During the sample period $\underline{k}$, after the error signal e(k) has been derived from the output of the filter it is used as the weighting coefficient for the fourth stage of register 2 and e(k-1) is used as the weighting coefficient for the fifth stage. The output of multiplier 14 is therefore $\mu[e(k) V1(k-3) + e(k-1) V(k-4)]$, i.e. the required correction for weighting coefficient $C_4$ for the fourth stage of register 2. The error signals e(k) and e(k-1) are now used, still during the sample period $\underline{k}$, as weighting coefficients for the third and fourth stages of register 2 respectively resulting in the required correction for the weighting coefficient $C_3$ for the third stage of register 2. During the next sample period, after the error signal e(k+1) has been derived from the output of the filter, the error signals e(k) and e(k-1) are again used as weighting coefficients for the third and fourth stages respectively of register 2, resulting in the required correction for the weighting coefficient $C_2$ for the second stage of register 2. The error signals e(k) and e(k-1) are then used, still during the sample period k+1, as weighting coefficients for the second and third stages respectively of register 2, giving the required correction for the weighting coefficient $C_1$ for the first stage of register 2. During the next sample

period $C_4$ and $C_3$ are corrected once again, and so on. It will be evident that the arrangement of Figure 1 and various timing interelationships therein will have to be modified slightly in order to achieve the operations illustrated in Figure 4 but the modifications required will be readily apparent to a person skilled in the art.

Obviously it is preferable to adjust, as described, each weighting coefficient C immediately the required correction therefor has been calculated, in order to minimise the settling time of the filter. However in some circumstances satisfactory results may still be obtained if, instead, a plurality of coefficients is adjusted every $\underline{m}$ sample periods, where $\underline{m}$ is greater than one. For example, the embodiment of Figure 1 could be modified so that all the N coefficients in register 9 are adjusted as a group each time the contents of register 18 are written into register 8.

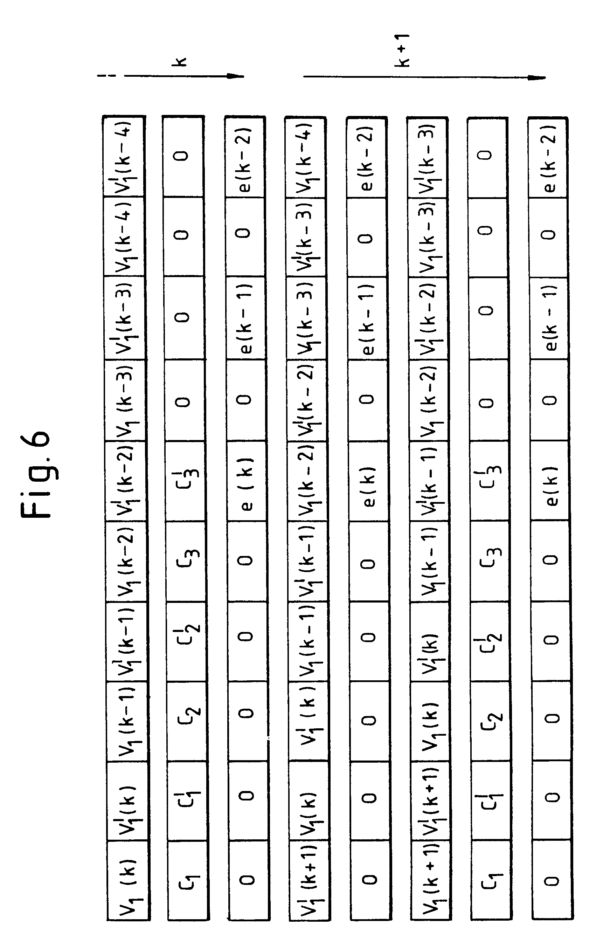

The invention has been described so far in the context of a simple linear filter. It will be evident that it may also be employed, for example, in a filter of the decision feedback type. To this end the filter 1 of Figure 1 together with items 8-10, 13, 14, 23, 25, 27 and 31 and their interconnections may be duplicated, the duplicate of filter 1 forming the feedback element of the filter arrangement. More specifically, the input 7 of the duplicate of filter 1 may be fed from the output 17 via a sign reverser, and the signal path from one input to the output of a further adder (not shown) may be included between the output 5 and demulitplexer 13 in Figure 1. That output of the duplicate of demultiplexer 13 which corresponds to the one which in Figure 1 is connected to decision element 15 and subtractor 16 is connected to the other input of the further adder, and the output of register 18 is also connected to the parallel input of the duplicate of register 8. The counters 31 and its duplicate are in such a case arranged to run in step, so that their contents are always equal to each other; these counters could be replaced by a single common counter if desired. Because of the provision of the sign reverser, during the first half of each input signal sample period the appropriately weighted N previous signals I at output 17 are now subtracted in the further adder from the suitably weighted N most recent input signal samples now present in register 2, and the result is applied to decision element 15 and subtractor 15 via multiplexer 13 as required. During the second half of each signal sample period a coefficient in register 9 is adjusted exactly as previously. Moreover a coefficient in the duplicate of register 9 is adjusted in the same way, the same error values $\underline{e}$ being used as the coefficients for the array 3 and its duplicate. For illustration, Figure 5 shows on successive lines, for a given sample period $\underline{k}$ corresponding to the first sample period illustrated in Figure 3, the respective contents V and V′ of register 2 and its duplicate (side by side), the respective weighting coefficients C and C′ employed in the array 3 and its duplicate during the first half of the sample period, and the respective weighting coefficients $\underline{e}$ employed in the array 3 and its duplicate during the second half of the sample period, where $V_1'(k)=-I(k-1)$. In this example a value of three has been chosen for $\underline{N}$ and $\underline{n}$ for both filter 1 and its duplicate although it will be evident that other values may be used and that $\underline{N}$ may be different from $\underline{n}$. Indeed the value of N (=$\underline{X}$ say) chosen for filter 1 may be different to the value of N (=$\underline{Y}$ say) chosen for the duplicate of filter 1, X+Y forming the number N of coefficients which are adjusted altogether.

It will be evident that two coefficients could alternatively be adjusted in both filter 1 and its duplicate for each input signal sample period, in the manner described above with reference to Figure 4. Moreover, instead of including a sign reverser between the output 17 and the input of the duplicate of filter 1, the signs of the coefficients C′ may themselves be reversed.

If desired the decision feedback filter arrangement described above may be modified so that only a single transversal filter 1 is employed, albeit of double length and albeit at the expense of having to increase the lengths of registers 8 and 9 and to carry out more operations serially during each input signal sample period. To this end, instead of connecting the output 17 of Figure 1 to a duplicate of filter 1 via a sign reverser it may be connected, via the sign reverser and one input and the output of a multiplexer, to the input 7 of filter 1, the output of the analog-to-digital converter being connected to the other input of this multiplexer. In such a case this multiplexer may be controlled to connect the output of converter 12 to input 7 during a first portion of each sample period of the input signal and to connect the output 17 to input 7 during a second portion of each period, shift register 2 now being clocked at double rate so that input signal samples $\underline{V}$ and the resulting output signals I are clocked into the register alternately, producing a content of register 2 as illustrated in the first line of Figure 6 at a specific time, where $V'(k)=-I(k-1)$. While this content is present it is now arranged that the two sets of weighting coefficients illustrated on the second and third lines of Figure 3 are employed in succession while demultiplexer 13 connects output 5 to items 15 and 16, and to multiplier 14, respectively. Thus during the first of these periods I(k) is produced at output 17 and e(k) is produced by subtractor 16, and during the second of these periods multiplier 14 produces the correction for coefficient $C_3'$. Register 2 is now clocked (fourth line of Figure 6) while maintaining the weighting coefficients the same (fifth line) and demultiplexer 13 in the state in which it connects output 5 to multiplier 14. Thus multiplier 14 now produces the correction for $C_3$. Register 2 is now clocked once again (sixth line of Figure 6) and the two sets of weighting coefficients illustrated on the seventh and eighth lines of Figure 6 are employed in succession while demultiplexer 13 connects output 5 to items 15 and 16 and to multiplier 14 respectively. Thus during the first of these periods I(k+1) is produced at output 17 and e(k+1) is produced by subtractor 16, and during the second of these periods multiplier 14 produces the correction for $C_2'$. Analogous operations are performed subsequently, resulting in the generation of the correction for $C_2$, I(k+2) and e(k+2), the corrections for $C_1'$ and $C_1$, and I(k+3) and e(k+3), after which the new errors are loaded into register 8 and the cycle repeats as from the third line of Figure 6. It will be noted that one of the N=6 coefficients is adjusted for each signal sample applied to the filter, so that each is adjusted once for every n=6 samples, that each correction is derived from n/2=3 error signals, and that n-2=4 further stages are provided in the filter subsequent to the first N stages.

Obviously some modifications will have to be made to the arrangement of Figure 1, and especially to the control pulse generator 35, to achieve the succession of operations described with reference to Figure 6, but these will be readily apparent to a person skilled in the art. Again, instead of including a sign reverser between the output 17' and the multiplexer supplying the input 7 of filter 1 the signs of the coefficients C' may themselves be reversed.

From reading the present disclosure, other modifications will be apparent to persons skilled in the art. Such modifications may involve other features which are already known in the design, manufacture and use of filter arrangements and component parts thereof and which may be used instead of or in addition to features already described herein. Although claims have been formulated in this application to particular combinations of features, it should be understood that the scope of the disclosure of the present application also includes any novel feature or any novel combination of features disclosed herein either explicitly or implicitly or any generalisation thereof, whether or not it relates to the same invention as presently claimed in any claim and whether or not it mitigates any or all of the same technical problems as does the present invention. The applicants hereby give notice that new claims may be formulated to such features and/or combinations of such features during the prosecution of the present application or of any further application derived therefrom.

## Claims

1. A method of adjusting the weighting coefficients corresponding to N successive stages of a transversal filter (1) according to the least mean squares algorithm, in which method signal samples are supplied to the filter in succession, differences between output signals of the filter and a reference are determined, which output signals each result from a respective group of N of said samples being weighted by said weighting coefficients, and a respective correction derived from the product of a said difference and the current content of a stage of the filter is applied to each said weighting coefficient, characterised in that the filter (1) includes at least one further stage which succeeds the N successive stages and the weighting coefficient corresponding to which is set to zero for the production of each said output signal, in that each of the N coefficients is adjusted only once for each $\underline{n}$ samples applied to the filter, where $\underline{n}$ is greater than unity, and in that each correction is derived from the output (5) of the filter after the entering of values representative of a plurality of said differences into the filter as respective weighting coefficients and the setting of any remaining weighting coefficients to zero.

2. A method as claimed in Claim 1, wherein a respective said output signal is produced for each signal sample applied to the filter (1), wherein the filter includes at least n-1 said further stages which succeed the N successive stages, and wherein each said plurality comprises $\underline{n}$ said differences.

3. A method as claimed in Claim 1 or Claim 2, wherein a respective said output signal is produced for each signal sample applied to the filter (1), and wherein n=N, one correction for a coefficient being derived for each sample applied to the filter.

4. A method as claimed in Claim 1, or Claim 2, wherein a respective said output signal is produced for each signal sample applied to the filter (1), and wherein N is even and n=N/2, two corrections for respective coefficients being derived for each sample applied to the filter.

5. A method as claimed in Claim 1, wherein a respective said output signal is produced for each pair of signal samples applied to the filter, and wherein alternate ones of said signal samples are derived from a said output signal via a decision element (15) and from an external signal source respectively.

6. A method as claimed in Claim 5, wherein one correction for a coefficient is derived for each sample applied to the filter.

7. A method as claimed in Claim 5 or Claim 6, wherein each said plurality comprises n/2 said differences and the filter includes at least n-2 said further stages which succeed the N successive stages.

8. A method of adjusting the weighting coefficients corresponding to N stages of a decision feedback filter arrangement according to the least mean squares algorithm, said filter arrangement comprising first and second transversal filters (1) having a common output (5) which is coupled to the input of the second filter via a decision element (15), X successive stages of the first filter and Y successive stages of the second filter together constituting said N stages, in which method signal samples are supplied to the first filter (1) in succession, differences between output signals appearing at said common output (5) and corresponding signals appearing at the decision element (15) output are determined, and a respective correction derived from the product of a said difference (c) and the current content of a stage of a said filter is applied to each said weighting coefficient, each said output signal appearing at said common output (5) resulting from a respective group of X of said samples and Y of the signals derived from the decision element (15) output which are applied to the second filter being weighted by said weighting coefficients, characterised in that the first filter (1) includes at least one further stage which succeeds said X successive stage and the second filter includes at least one further stage which succeeds said Y successive stage, the weighting coefficients corresponding to said further stages being set to zero for the production of each said output signal appearing at said common output (5), in that each of the N coefficients is adjusted only once for each n samples applied to the first filter, where n is greater than unity, in that each correction for a weighting coefficient corresponding to one of the X stages of the first filter is derived from the output of the first filter after the entering of values representative of a plurality of said differences into the first filter as respective weighting coefficients and the setting of any remaining weighting coefficients therein to zero, and in that each correction for a weighting coefficient corresponding to one of the Y stages of the second filter is derived from the output of the second filter after the entering of values representative of a plurality of said differences into the second filter as respective weighting coefficients and the setting of any remaining weighting coefficients therein to zero.

9. A method as claimed in Claim 8, wherein a respective said output signal appearing at said common output (5) is produced for each signal sample applied to the first filter (1), wherein each of the first and second filters includes at least n-1 said further stages, and wherein each said plurality comprises n said differences.

10. A method as claimed in Claim 8 or Claim 9, wherein a respective said output signal appearing at said common output (5) is produced for each signal sample applied to the first filter, wherein n=N/2 and X=Y, and wherein corrections for one coefficient in each filter are derived for each sample applied to the first filter.

11. A method as claimed in any of Claims 8 to 10, wherein a respective said output signal appearing at said common output (5) is produced for each signal sample applied to the first filter, wherein n=N/4 and X=Y, and wherein corrections for two coefficients in each filter are derived for each sample applied to the first filter.

12. A transversal filter arrangement comprising a transversal filter (1) having at least N successive stages, means (12) for supplying signal samples to the filter in succession, means (16) for determining differences between output signals of the filter and a reference, which output signals each result from a respective group of N of said samples being weighted by the weighting coefficients corresponding to the N successive stages, and weighting coefficient adjusting means (9,10,14,23,25,26) for adjusting each said weighting coefficient according to the least mean squares algorithm by applying to the coefficient a respective correction derived from the product of a said difference and the current content of a stage of the filter, characterised in that the filter (1) includes at least one further stage which succeeds the N successive stages, in that means are provided for setting the weighting coefficient corresponding to said further stage to zero for the production of each said weighting coefficient, and in that said weighting coefficient adjusting means (9,10,14,23,25 and 26) is arranged to adjust each of the N coefficients only once for each n samples applied to the filter, where n is greater than unity, and to derive each correction from the output of the filter after entering values representative of a plurality of said differences into the filter as respective weighting coefficients and setting any remaining weighting coefficients to zero.

13. A decision feedback filter arrangement comprising first and second transversal filters (1) having a common output (5) which is coupled to the input of the second filter via a decision element (15), means (12) for supplying signal samples to the first filter in succession, means (16) for determining differences between signals appearing at said common output and corresponding signals appearing at the decision element (15) output, and weighting coefficient adjusting means (8,9,10) for adjusting the weighting coefficients corresponding to X successive stages of the first filter and Y successive stages of the second filter in accordance with the least mean squares algorithm by applying to each said weighting coefficient a respective correction derived from the product of a said difference and the current content of stage of a said filter, each said output signal appearing at said common output (5) resulting from a respective group of X of said samples and Y of the signals derived from the decision element (15) output which are applied to the second filter being weighted by said weighting coefficients, characterised in that the first filter (1) includes at least one further stage which succeeds said X successive stages and the second filter includes at least one further stage which succeeds said Y successive stages, in that means are provided for setting the weighting coefficients corresponding to said further stages to zero for the production of each said output signal appearing at said common output (5), and in that said weighting coefficient adjusting means is arranged to adjust each of the X+Y coefficients only once for each $n$ samples applied to the first filter, where $n$ is greater than unity, to derive each correction for a weighting coefficient corresponding to one of the X stages of the first filter (1) from the output of the first filter after entering values representative of a plurality of said differences into the first filter as respective weighting coefficients and setting any remaining weighting coefficients to zero, and to derive each correction for a weighting coefficient corresponding to one of the Y stages of the second filter from the output of the second filter after entering values representative of a plurality of said differences into the second filter as respective weighting coefficients and setting any remaining weighting coefficients therein to zero.

**Patentansprüche**

1. Ein Verfahren zur Einstellung der Bewertungskoeffizienten in N aufeinanderfolgenden Stufen eines Transversal-Filters (1) gemäß der Methode der kleinsten mittleren Quadrate, bei dem Signalstichproben nacheinander an den Filter übermittelt werden, die Differenzen zwischen den einzelnen Ausgabesignalen des Filters und einem Richtwert gemessen werden, wobei die Ausgabesignale auf einer entsprechenden Gruppe von N der genannten Stichproben basieren, die mit Hilfe der genannten Bewertungskoeffizienten gewichtet werden, und bei dem eine entsprechende Korrektur, die sich aus dem Produkt der genannten Differenz und dem aktuellen Inhalt der Filterstufe ergibt, auf jeden Bewertungskoeffizienten übertragen wird, dadurch charakterisiert, daß der Filter (1) über die N aufeinanderfolgenden Stufe hinaus mindestens über eine weitere Stufe verfügt, deren zugehöriger Bewertungskoeffizient zur Erzeugung aller genannten Ausgabesignale auf Null gestellt wird, daß jeder der N Koeffizienten bei jeder der $n$ am Filter vorgenommenen Stichproben nur einmal eingestellt wird, wobei $n$ größer als Eins ist, und daß jede Korrektur aus der Ausgabe (5) des Filters abgeleitet wird, nachdem die für die genannten Differenzen charakteristischen Werte als die jeweiligen Bewertungskoeffizienten in den Filter eingegeben und alle übrigen Bewertungskoeffizienten auf Null gestellt wurden.

2. Ein Verfahren gemäß Anspruch 1, bei dem für jede an dem Filter (1) vorgenommene Signalstichprobe ein entsprechendes Ausgabesignal erzeugt wird, bei dem der Filter mindestens n-1 der genannten zusätzlichen Stufen im Anschluß an die N aufeinanderfolgenden Stufen umfaßt und bei dem die genannten charakteristischen Werte $n$ der genannten Differenzen aufweisen.

3. Ein Verfahren gemäß Anspruch 1 oder Anspruch 2, bei dem für jede an dem Filter (1) vorgenommene Signalstichprobe ein entsprechendes Ausgabesignal erzeugt wird und bei dem n=N, so daß für jede an dem Filter vorgenommene Signalstichprobe eine Korrektur des Koeffizienten vorgenommen wird.

4. Ein Verfahren gemäß Anspruch 1 oder Anspruch 2, bei dem für jede an dem Filter (1) vorgenommene Signalstichprobe ein entsprechendes Ausgabesignal erzeugt wird und bei dem N eine gerade Zahl ist und N=N/2 gilt, so daß für jede an dem Filter vorgenommene Signalstichprobe zwei Korrekturen des Koeffizienten vorgenommen werden.

5. Ein Verfahren gemäß Anspruch 1, bei dem für jedes an dem Filter genommene Signalstichprobenpaar ein entsprechendes Ausgabesignal erzeugt wird und bei dem aus dem genannten Ausgabesignal mit Hilfe eines Entscheidungselements (15) bzw. einer externen Signalquelle zu den genannten Signalstichproben alternierende Signale abgeleitet werden.

6. Ein Verfahren gemäß Anspruch 5, bei dem für jede an dem Filter vorgenommene Signalstichprobe eine entsprechende Korrektur des Koeffizienten abgeleitet wird.

7. Ein Verfahren gemäß Anspruch 5 oder Anspruch 6, bei dem die genannten charakteristischen Werte n/2 der genannten Differenzen aufweisen und der Filter mindestens n-2 der genannten zusätzlichen Stufen im Anschluß an die N aufeinanderfolgenden Stufen umfaßt.

8.  Ein Verfahren zur Einstellung der Bewertungskoeffizienten in N Stufen eines Empfangsbestätigungsfilters gemäß der Methode der kleinsten mittleren Quadrate, bei dem der genannte Filter aus einem ersten und einem zweiten Transversal-Filter (1) mit gemeinsamer Ausgabe (5) besteht, die mit Hilfe eines Entscheidungselements (15) mit der Eingabe des zweiten Filters gekoppelt ist, bei dem X aufeinanderfolgende Stufen im ersten Filter und Y aufeinanderfolgende Stufen im zweiten Filter zusammen die genannten N Stufen bilden, bei dem aufeinanderfolgende Signalstichproben nacheinander auf den ersten Filter (1) abgegeben werden, Differenzen zwischen den an der genannten gemeinsamen Ausgabe (5) erzeugten Signalen und den entsprechenden, an der Ausgabe des Entscheidungselements (15) erzeugten Signalen gemessen werden, sowie auf der Grundlage des Produkts der genannten Differenz (c) und dem aktuellen Inhalt einer Stufe des genannten Filters eine entsprechende Korrektur abgeleitet und auf jeden Bewertungskoeffizienten angewandt wird, wobei alle an der genannten gemeinsamen Ausgabe (5) abgeleiteten Signale einer jeweiligen Gruppe aus X der genannten Stichproben und Y der an der Ausgabe des Entscheidungselements (15) des zweiten Filters abgeleiteten Signale mit Hilfe der genannten Bewertungskoeffizienten gewichtet werden, dadurch charakterisiert, daß der erste Filter (1) mindestens eine weitere Stufe im Anschluß an die X aufeinanderfolgenden Stufen und der zweite Filter mindestens eine weitere Stufe im Anschluß an die Y aufeinanderfolgenden Stufen umfassen, daß die Bewertungskoeffizienten der genannten weiteren Stufen zur Erzeugung aller genannten Signale, die an der genannten gemeinsamen Ausgabe (5) anliegen auf Null gestellt werden, daß jeder der N Koeffizienten bei jeder der n am ersten Filter vorgenommenen Stichproben nur einmal eingestellt wird, wobei n größer als Eins ist, daß jede Korrektur eines, den X Stufen des ersten Filters entsprechenden Bewertungskoeffizienten von der Ausgabe des ersten Filters abgeleitet wird, nachdem die für die genannten Differenzen charakteristischen Werte als die jeweiligen Bewertungskoeffizienten in den ersten Filter eingegeben und alle übrigen, darin enthaltenen Bewertungskoeffizienten auf Null gestellt wurden, und daß jede Korrektur eines, den Y Stufen des zweiten Filters entsprechenden Bewertungskoeffizienten von der Ausgabe des zweiten Filters abgeleitet wird, nachdem die für die genannten Differenzen charakteristischen Werte als die jeweiligen Bewertungskoeffizienten in den zweiten Filter eingegeben und alle übrigen, darin enthaltenen Bewertungskoeffizienten auf Null gestellt wurden.

9.  Verfahren gemäß Anspruch 8, bei dem für jede am ersten Filter (1) vorgenommene Signalstichprobe ein entsprechendes Ausgabesignal an der genannten gemeinsamen Ausgabe (5) erzeugt wird, bei dem jeder erste und zweite Filter mindestens n-1 weitere Stufen umfassen und bei dem die genannten charakteristischen Werte n der genannten Differenzen aufweisen.

10.  Verfahren gemäß Anspruch 8 oder Anspruch 9, bei dem für jede am ersten Filter vorgenommene Signalstichprobe ein entsprechendes Ausgabesignal an der genannten gemeinsamen Ausgabe (5) erzeugt wird, bei dem n=N/2 ist und X=Y gilt, und bei dem die Korrekturen eines Koeffizienten in jedem Filter von der am ersten Filtern vorgenommenen Stichprobe abgeleitet werden.

11.  Verfahren gemäß eines der Ansprüche 8 bis 10, bei dem für jede am ersten Filter vorgenommene Signalstichprobe ein entsprechendes Ausgabesignal an der genannten gemeinsamen Ausgabe (5) erzeugt wird, bei dem n=N/4 ist und X=Y gilt, und bei dem die Korrekturen von zwei Koeffizienten in jedem Filter von der am ersten Filtern vorgenommenen Stichprobe abgeleitet werden.

12.  Ein Transversal-Filter, bestehend aus einem eigentlichen Transversal-Filter (1) mit mindestens N aufeinanderfolgenden Stufen, Einrichtungen (12) zur Erzeugung von aufeinanderfolgenden Signalstichproben am Filter, Einrichtungen (16) zur Feststellung der Differenzen zwischen den Ausgabesignalen des Filters und einem Richtwert, wobei alle Ausgabesignale aus einer entsprechenden Gruppe der genannten N Signalstichproben stammen und mit Hilfe der den N aufeinanderfolgenden Stufen entsprechenden Bewertungskoeffizienten gewichtet werden, und Einrichtungen (9, 10, 14, 23, 25, 26) zur Einstellung aller genannten Bewertungskoeffizienten gemäß der Methode der kleinsten mittleren Quadrate durch Ausführung einer entsprechenden Korrektur, abgeleitet aus dem Produkt einer genannten Differenz und dem aktuellen Inhalt einer Filterstufe, dadurch charakterisiert, daß der Filter (1) im Anschluß an die N aufeinanderfolgenden Stufen mindestens eine weitere Stufe umfaßt, daß er Einrichtungen umfaßt, um den Bewertungskoeffizienten der genannten weiteren Stufe zur Erzeugung aller genannten Bewertungskoeffizienten auf Null zu stellen, und daß die genannten Mittel (9, 10, 14, 23, 25 und 26) zur Einstellung der Bewertungskoeffizienten so angelegt sind, daß jeder der N Koeffizienten lediglich einmal für jede der n am Filter eintreffenden Signalstichproben eingestellt werden muß, wobei n größer als Eins ist, und daß jede Korrektur von der Filterausgabe abgeleitet wird, nachdem die für die genannten Differenzen charakteristischen Werte als die jeweiligen Bewertungskoeffizienten in den Filter eingegeben und alle übrigen, darin enthaltenen Bewertungskoeffizienten auf Null gestellt wurden.

13. Ein Empfangsbestätigungsfilter, bestehend aus einem ersten und einem zweiten Transversal-Filter (1) mit gemeinsamer Ausgabe (5), die mit Hilfe eines Entscheidungselements (15) an die Eingabe des zweiten Filters gekoppelt ist, Einrichtungen (12) zur Übermittlung von aufeinanderfolgenden Signalstichproben auf den ersten Filter, Einrichtungen (16) zur Feststellung von Differenzen zwischen den an der genannten gemeinsamen Ausgabe erzeugten Signalen und den entsprechenden, an der Ausgabe des Entscheidungselements (15) erzeugten Signalen, sowie Einrichtungen (8, 9, 10) zur Einstellung der Bewertungskoeffizienten auf X aufeinanderfolgenden Stufen im ersten Filter und Y aufeinanderfolgenden Stufen im zweiten Filter gemäß der Methode der kleinsten mittleren Quadrate durch Ausführung einer entsprechenden Korrektur, abgeleitet aus dem Produkt einer genannten Differenz und dem aktuellen Inhalt einer Stufe des genannten Filters, wobei alle an der genannten gemeinsamen Ausgabe (5) eintreffenden Ausgabesignale einer jeweiligen Gruppe aus X der genannten Signalstichproben und Y der an der Ausgabe des Entscheidungselements (15) des zweiten Filters eintreffenden Signale mit Hilfe der genannten Bewertungskoeffizienten gewichtet werden, dadurch charakterisiert, daß der erste Filter (1) mindestens eine weitere Stufe im Anschluß an die X aufeinanderfolgenden Stufen und der zweite Filter mindestens eine weitere Stufe im Anschluß an die Y aufeinanderfolgenden Stufen umfassen, daß er Einrichtungen umfaßt, um den Bewertungskoeffizienten der genannten weiteren Stufen zur Erzeugung aller genannten Ausgabesignale, die an der genannten gemeinsamen Ausgabe (5) anliegen, auf Null zu stellen, und daß die genannten Mittel zur Einstellung der Bewertungskoeffizienten so angelegt sind, daß jeder der Koeffizienten X+Y lediglich einmal für jede der n am ersten Filter vorgenommenen Signalstichproben eingestellt werden muß, wobei n größer als Eins ist, und daß jede Korrektur eines, den X Stufen des ersten Filters (1) entsprechenden Bewertungskoeffizienten an der Ausgabe des ersten Filters vorgenommen wird, nachdem die für die genannten Differenzen charakteristischen Werte als die jeweiligen Bewertungskoeffizienten in den ersten Filter eingegeben und alle übrigen, darin enthaltenen Bewertungskoeffizienten auf Null gestellt wurden, und daß jede Korrektur eines, den Y Stufen des zweiten Filters entsprechenden Bewertungskoeffizienten an der Ausgabe des zweiten Filters vorgenommen wird, nachdem die für die genannten Differenzen charakteristischen Werte als die jeweiligen Bewertungskoeffizienten in den zweiten Filter eingegeben und alle übrigen, darin enthaltenen Bewertungskoeffizienten auf Null gestellt wurden.

## Revendications

1. Procédé de réglage des coefficients de pondération correspondant à N étages successifs d'un filtre transversal (1) selon l'algorithme des moindres carrés moyens, procédé dans lequel des échantillons de signaux sont acheminés au filtre en succession, les différences entre les signaux de sortie du filtre et une référence sont déterminées, lesdits signaux de sortie résultant chacun d'un groupe respectif de N desdits échantillons pondérés par lesdits coefficients de pondération, et une correction respective dérivée du produit d'une dite différence et du contenu courant d'un étage du filtre est appliquée à chaque coefficient de pondération, caractérisé en ce que le filtre (1) comprend au moins un autre étage qui succède aux N étages successifs et dont le coefficient de pondération correspondant est mis à zéro pour la production de chaque signal de sortie, en ce que chacun des N coefficients est réglé une fois seulement pour chacun des n échantillons appliqués au filtre, où n est plus grand que l'unité, et en ce que chaque correction est dérivée de la sortie (5) du filtre après l'introduction de valeurs représentatives d'une pluralité desdites différences dans le filtre comme coefficients de pondération respectifs et la mise à zéro des coefficients de pondération restants éventuels.

2. Procédé selon la revendication 1, dans lequel un dit signal de sortie respectif est produit pour chaque échantillon de signal appliqué au filtre (1), dans lequel le filtre comprend au moins n-1 autres étages qui succèdent aux N étages successifs, et dans lequel chaque pluralité comprend n différences.

3. Procédé selon la revendication 1 ou la revendication 2, dans lequel un signal de sortie respectif est produit pour chaque échantillon de signal appliqué au filtre (1) et dans lequel n = N, une correction pour un coefficient étant dérivée pour chaque échantillon appliqué au filtre.

4. Procédé selon la revendication 1 ou 2, dans lequel un signal de sortie respectif est produit pour chaque échantillon de signal appliqué au filtre (1) et dans lequel N est pair et n = N/2, deux corrections pour des coefficients respectifs étant dérivées pour chaque échantillon appliqué au filtre.

5. Procédé selon la revendication 1, dans lequel un signal de sortie respectif est produit pour chaque paire d'échantillons de signaux appliquée au filtre et dans lequel des signaux alternés desdits échantillons de signaux sont dérivés d'un signal de sortie via un élément de décision (15) et provenant de source de signaux externe, respectivement.

6. Procédé selon la revendication 5, dans lequel une correction pour un coefficient est dérivée pour chaque échantillon appliqué au filtre.

7. Procédé selon la revendication 5 ou 6, dans lequel chaque pluralité comprend n/2 différences et le filtre comprend au moins n-2 autres étages qui succèdent aux N étages successifs.

8. Procédé de réglage des coefficients de pondération correspondant à N étages d'un agencement de filtrage à rétroaction de décision selon l'algorithme des moindres carrés moyens, ledit agencement de filtrage comprenant un premier et un deuxième filtres transversaux (1) ayant une sortie commune (5) qui est couplée à l'entrée du deuxième filtre via un élément de décision (15), X étages successifs du premier filtre et Y étages successifs du deuxième filtre constituant ensemble lesdits N étages, procédé dans lequel des échantillons de signaux sont fournis au premier filtre (1) en succession, des différences entre les signaux de sortie apparaissant à ladite sortie commune (5) et des signaux correspondants apparaissant à la sortie de l'élément de décision (15) sont déterminées, et une correction respective tirée du produit d'une différence (c) et du contenu courant d'un étage d'un filtre est appliquée à chaque coefficient de pondération, chaque signal de sortie apparaissant à ladite sortie commune (5) résultant d'un groupe respectif de X des échantillons et de Y des signaux dérivés de la sortie de l'élément de décision (15) qui sont appliqués au deuxième filtre, pondérés par lesdits coefficients de pondération, caractérisé en ce que le premier filtre (1) comprend au moins un autre étage qui succède auxdits X étages successifs et le deuxième filtre comprend au moins un autre étage qui succède auxdits Y étages successifs, les coefficients de pondération correspondant auxdits autres étages étant mis à zéro pour la production de chaque signal de sortie apparaissant à ladite sortie commune (5), en ce que chacun des N coefficients n'est réglé qu'une fois pour chaque quantité de $n$ échantillons appliqués au premier filtre, où $n$ est supérieur à l'unité, en ce que chaque correction pour un coefficient de pondération correspondant à l'un des X étages du premier filtre est dérivée de la sortie du premier filtre après l'introduction de valeurs représentatives d'une pluralité desdites différences dans le premier filtre en tant que coefficients de pondération respectifs et la mise à zéro des coefficients de pondération restants éventuels, et en ce que chaque correction pour un coefficient de pondération correspondant à l'un des Y étages du deuxième filtre est dérivée de la sortie du deuxième filtre après l'introduction de valeurs représentatives d'une pluralité desdites différences dans le deuxième filtre comme coefficients de pondération respectifs et la mise à zéro des coefficients de pondération restants éventuels.

9. Procédé selon la revendication 8, dans lequel un dit signal de sortie respectif apparaissant à ladite sortie commune (5) est produit pour chaque échantillon de signal appliqué au premier filtre (1), dans lequel chacun des premier et deuxième filtres comprend au moins n-1 autres étages et dans lequel chaque pluralité comprend $n$ différences.

10. Procédé selon la revendication 8 ou 9, dans lequel un signal de sortie respectif apparaissant à ladite sortie commune (5) est produit pour chaque échantillon de signal appliqué au premier filtre, dans le lequel n = N/2 et X = Y, et dans lequel des corrections pour un coefficient de chaque filtre sont dérivées pour chaque échantillon appliqué au premier filtre.

11. Procédé selon l'une quelconque des revendications 8 à 10, dans lequel un signal de sortie respectif apparaissant à ladite sortie commune (5) est produit pour chaque échantillon de signal appliqué au premier filtre, dans lequel n = N/4 et X = Y, et dans lequel des corrections pour deux coefficients de chaque filtre sont dérivées pour chaque échantillon appliqué au premier filtre.

12. Agencement de filtrage transversal comprenant un filtre transversal (1) ayant au moins N étages successifs, des moyens (12) pour acheminer des échantillons de signaux au filtre en succession, des moyens (16) pour déterminer des différences entre les signaux de sortie du filtre et une référence, lesdits signaux de sortie résultant chacun d'un groupe respectif de N desdits échantillons qui sont pondérés par les coefficients de pondération correspondant aux N étages successifs, et des moyens de réglage des coefficients de pondération (9, 10, 14, 23, 25, 26) pour régler chaque coefficient de pondération selon l'algorithme des moindres carrés moyens en appliquant au coefficient une correction respective dérivée du produit d'une dite différence et du contenu courant d'un étage du filtre, caractérisé en ce que le filtre (1) comprend au moins un autre étage qui succède aux N étages successifs, en ce que des moyens sont prévus pour mettre à zéro le coefficient de pondération correspondant audit autre étage en vue de la production de chaque coefficient de pondération, et en ce que lesdits moyens de réglage des coefficients de pondération (9, 10, 14, 23, 25 et 26) sont agencés pour régler chacun des N coefficients une fois seulement pour chaque quantité de $n$ échantillons appliqués au filtre, où $n$ est supérieur à l'unité, et pour tirer chaque correction de la sortie du filtre après introduction des valeurs représentatives d'une pluralité desdites différences dans le filtre comme coefficients de pondération respectifs et la mise à zéro des coefficients de pondération restants éventuels.

13. Agencement de filtrage à rétroaction de décision comprenant un premier et un deuxième filtres transversaux (1) ayant une sortie commune (5) qui est couplée à l'entrée du deuxième filtre via un élément de décision (15), des moyens (12) pour fournir des échantillons de signaux au premier filtre en succession, des moyens (16) pour déterminer des différences entre des signaux apparaissant à ladite sortie commune et des signaux correspondants apparaissant à la sortie de l'élément de décision (15), et des moyens de réglage des coefficients de pondération (8, 9, 10) pour régler les coefficients de pondération correspondant à X étages successifs du premier filtre et à Y étages successifs du deuxième filtre conformément à l'algorithme des moindres carrés moyens en appliquant à chaque dit coefficient de pondération une correction respective dérivée du produit de ladite différence et du contenu courant de l'étage d'un dit filtre, chaque signal de sortie apparaissant à ladite sortie commune (5) résultant d'un groupe respectif de X desdits échantillons et de Y desdits signaux dérivés de la sortie de l'élément de décision (15) qui sont appliqués au deuxième filtre pondéré par lesdits coefficients de pondération, caractérisé en ce que le premier filtre (1) comprend au moins un autre étage qui succède auxdits X étages successifs et le deuxième filtre comprend au moins un autre étage qui succède auxdits Y étages successifs, en ce que des moyens sont prévus pour mettre à zéro les coefficients de pondération correspondant auxdits autres étages en vue de la production de chaque signal de sortie apparaissant à ladite sortie commune (5), et en ce que lesdits moyens de réglage des coefficients de pondération sont agencés pour régler chacun des X + Y coefficients une fois seulement pour chaque quantité de $n$ échantillons appliqués au premier filtre, où $n$ est supérieur à l'unité, pour tirer chaque correction pour un coefficient de pondération correspondant à l'un des X étages du premier filtre (1) de la sortie du premier filtre après introduction de valeurs représentatives d'une pluralité desdites différences dans le premier filtre comme coefficients de pondération respectifs et mise à zéro des coefficients de pondération restants éventuels, et pour tirer chaque correction d'un coefficient de pondération correspondant à l'un des Y étages du deuxième filtre de la sortie du deuxième filtre après introduction de valeurs représentatives d'une pluralité desdites différences dans le deuxième filtre comme coefficients de pondération respectifs et mise à zéro des coefficients de pondération restants éventuels.

# Fig. 1

EP 0 322 060 B1

# Fig.5

| $V_1(k)$ | $V_1(k-1)$ | $V_1(k-2)$ | $V_1(k-3)$ | $V_1(k-4)$ |
|---|---|---|---|---|
| $C_1$ | $C_2$ | $C_3$ | 0 | 0 |
| 0 | 0 | $e(k)$ | $e(k-1)$ | $e(k-2)$ |

| $V_1^I(k)$ | $V_1^I(k-1)$ | $V_1^I(k-2)$ | $V_1^I(k-3)$ | $V_1^I(k-4)$ |
|---|---|---|---|---|
| $C_1^I$ | $C_2^I$ | $C_3^I$ | 0 | 0 |
| 0 | 0 | $e(k)$ | $e(k-1)$ | $e(k-2)$ |

k

# Fig.2

A

B

C

D

E

EP 0 322 060 B1

# Fig. 3

| | | | | |
|---|---|---|---|---|
| $V_1$ (k) | $V_1$ (k-1) | $V_1$ (k-2) | $V_1$ (k-3) | $V_1$ (k-4) |

| | | | | |
|---|---|---|---|---|
| $C_1$ | $C_2$ | $C_3$ | 0 | 0 |

k

| | | | | |
|---|---|---|---|---|
| 0 | 0 | e (k) | e(k-1) | e(k-2) |

| | | | | |
|---|---|---|---|---|
| $V_1$ (k+1) | $V_1$ (k) | $V_1$ (k-1) | $V_1$ (k-2) | $V_1$ (k-3) |

| | | | | |
|---|---|---|---|---|
| $C_1$ | $C_2$ | $C_3$ | 0 | 0 |

k+1

| | | | | |
|---|---|---|---|---|
| 0 | 0 | e (k) | e(k-1) | e (k-2) |

| | | | | |
|---|---|---|---|---|
| $V_1$ (k+2) | $V_1$(k+1) | $V_1$ (k) | $V_1$ (k-1) | $V_1$ (k-2) |

| | | | | |
|---|---|---|---|---|
| $C_1$ | $C_2$ | $C_3$ | 0 | 0 |

k+2

| | | | | |
|---|---|---|---|---|
| 0 | 0 | e (k) | e (k-1) | e (k-2) |

| | | | | |
|---|---|---|---|---|
| $V_1$ (k+3) | $V_1$ (k+2) | $V_1$ (k+1) | $V_1$ (k) | $V_1$ (k-1) |

| | | | | |
|---|---|---|---|---|
| $C_1$ | $C_2$ | $C_3$ | 0 | 0 |

k+3

| | | | | |
|---|---|---|---|---|
| 0 | 0 | e(k+3) | e(k+2) | e(k+1) |

# Fig. 4

| $V_1(k)$ | $V_1(k-1)$ | $V_1(k-2)$ | $V_1(k-3)$ | $V_1(k-4)$ |
|---|---|---|---|---|
| $C_1$ | $C_2$ | $C_3$ | $C_4$ | 0 |
| 0 | 0 | 0 | $e(k)$ | $e(k-1)$ |
| 0 | 0 | $e(k)$ | $e(k-1)$ | 0 |

k

| $V_1(k+1)$ | $V_1(k)$ | $V_1(k-1)$ | $V_1(k-2)$ | $V_1(k-3)$ |
|---|---|---|---|---|
| $C_1$ | $C_2$ | $C_3$ | $C_4$ | 0 |
| 0 | 0 | $e(k)$ | $e(k-1)$ | 0 |
| 0 | $e(k)$ | $e(k-1)$ | 0 | 0 |

k+1

| $V_1(k+2)$ | $V_1(k+1)$ | $V_1(k)$ | $V_1(k-1)$ | $V_1(k-2)$ |
|---|---|---|---|---|
| $C_1$ | $C_2$ | $C_3$ | $C_4$ | 0 |
| 0 | 0 | 0 | $e(k+2)$ | $e(k+1)$ |
| 0 | 0 | $e(k+2)$ | $e(k+1)$ | 0 |

k+2

# Fig. 6

| | | | | | | | | | |
|---|---|---|---|---|---|---|---|---|---|
| $V_1(k)$ | $V_1^l(k)$ | $V_1(k-1)$ | $V_1^l(k-1)$ | $V_1(k-2)$ | $V_1^l(k-2)$ | $V_1(k-3)$ | $V_1^l(k-3)$ | $V_1(k-4)$ | $V_1^l(k-4)$ |
| $C_1$ | $C_1^l$ | $C_2$ | $C_2^l$ | $C_3$ | $C_3^l$ | 0 | 0 | 0 | 0 |
| 0 | 0 | 0 | 0 | 0 | $e(k)$ | 0 | $e(k-1)$ | 0 | $e(k-2)$ |
| $V_1^l(k+1)$ | $V_1(k)$ | $V_1^l(k)$ | $V_1(k-1)$ | $V_1^l(k-1)$ | $V_1(k-2)$ | $V_1^l(k-2)$ | $V_1(k-3)$ | $V_1^l(k-3)$ | $V_1(k-4)$ |
| 0 | 0 | 0 | 0 | 0 | $e(k)$ | 0 | $e(k-1)$ | 0 | $e(k-2)$ |
| $V_1(k+1)$ | $V_1^l(k+1)$ | $V_1(k)$ | $V_1^l(k)$ | $V_1(k-1)$ | $V_1^l(k-1)$ | $V_1(k-2)$ | $V_1^l(k-2)$ | $V_1(k-3)$ | $V_1^l(k-3)$ |
| $C_1$ | $C_1^l$ | $C_2$ | $C_2^l$ | $C_3$ | $C_3^l$ | 0 | 0 | 0 | 0 |
| 0 | 0 | 0 | 0 | 0 | $e(k)$ | 0 | $e(k-1)$ | 0 | $e(k-2)$ |

k

k+1

EP 0 322 060 B1